# EUROPÄISCHE PATENTSCHRIFT

(11) **EP 1 269 640 B1**
(45) Veröffentlichungstag und Bekanntmachung des Hinweises auf die Patenterteilung: **09.02.2005**
(21) Anmeldenummer: 01927615.3
(22) Anmeldetag: 27.03.2001
(51) Int. Cl.: H04B 1/16, H04B 1/10

(54) **MOBILFUNKGERÄT UND VERFAHREN ZUM EMPFANG EINES HF-SIGNALS**
MOBILE RADIO DEVICE AND A METHOD FOR RECEIVING AN HF SIGNAL
RADIOTELEPHONE MOBILE ET PROCEDE POUR RECEVOIR UN SIGNAL HF

(30) Priorität: 31.03.2000 DE 10016232
(43) Veröffentlichungstag der Anmeldung: 02.01.2003
(73) Patentinhaber: SIEMENS AKTIENGESELLSCHAFT, 80333 München (DE)
(72) Erfinder: ENGELHARDT, Thomas, 81476 München (DE)
(86) Internationale Anmeldenummer: PCT/DE2001/001170
(87) Internationale Veröffentlichungsnummer: WO 2001/076082

(56) Entgegenhaltungen:
- EP-A- 0 814 567
- WO-A-99/56401
- US-A- 5 390 345

## Beschreibung

Die Erfindung betrifft ein Verfahren zum Empfang eines HF-Signals, das aus einem Nutzsignalanteil und einem Störsignalanteil besteht, wobei zumindest der Nutzsignalanteil einem Empfänger zugeleitet wird, der das Signal verstärkt, filtert, demoduliert und ausgibt. Weiterhin betrifft die Erfindung ein Mobilfunkgerät, mit mindestens einem Empfänger, der mindestens einen Verstärker enthält, und mindestens einem Sender, zur Übertragung und zum Empfang eines HF-Signals, das aus einem Nutzsignalanteil und einem Störsignalanteil besteht.

In der Mobilkommunikation werden weltweit immer leistungsfähigere Mobilkommunikationsnetze sowie immer kleinere und preisgünstigere Endgeräte entwickelt. Um einen störungsfreien Betrieb dieser Endgeräte zu gewährleisten, müssen die in den Endgeräten enthaltenen Sende- und Empfangsteile bestimmte spezifizierte Anforderungen erfüllen, wie zum Beispiel die Spezifikation GSM 05.05. Diese Spezifikation gilt für ein Mobilfunkgerät, das im GSM-Mobilkommunikationsnetz sendet und empfängt. Für Mobilfunkgeräte, die in anderen Mobilkommunikationsnetzen arbeiten, gelten entsprechende Spezifikationen. So muß ein Mobilfunkgerät zum Beispiel in der Lage sein, in einem bestimmten Frequenzbereich, trotz eines Störsignals, ein Nutzsignal in einer definierten Qualität zu empfangen. Diese Fähigkeit wird Großsignalfestigkeit genannt.

In EP 0 814 567 wird ein variabler RF Signal Verstärker offenbart, der angepasst wird, um eine erforderliche Intermodulationsperformanz bei gegebenen Empfangsbedingungen zu erzielen.

In der Praxis werden die Endgeräte häufig so ausgelegt, daß sie die spezifizierten Anforderungen, insbesondere hinsichtlich der Großsignalfestigkeit, immer erfüllen, unabhängig davon, ob dies bei den augenblicklich herrschenden Umgebungsbedingungen überhaupt nötig ist. Dies führt dazu, daß die Stromaufnahme häufig höher als erforderlich ist, und sich hierdurch die Betriebszeit des Mobilfunkgerätes unnötig verkürzt, oder eine größere und teurere Batterie benötigt wird.Es ist daher Aufgabe der Erfindung, ein Verfahren zur Verfügung zu stellen, das es ermöglicht, die Betriebszeit eines Mobilfunkgerätes zu verlängern, ohne daß die Leistung der Batterie erhöht oder eine größere Batterie verwendet wird. Weiterhin soll ein Mobilfunkgerät zur Durchführung des erfindungsgemäßen Verfahrens entwickelt werden.

Die Aufgabe zur Entwicklung eines Verfahrens wird durch die Merkmale des ersten Verfahrensanspruches, die Aufgabe zur Entwicklung eines Mobilfunkgerätes wird durch die Merkmale des ersten Vorrichtungsanspruches gelöst.

Der Erfinder hat erkannt, daß es möglich ist, die Betriebszeit eines Mobilfunkgerätes zu verlängern, indem der tatsächliche Strombedarf des Mobilfunkgerätes durch die Messung eines Störsignals, wobei der Störsignalanteil aus der Messung eines gesamten eingehenden HF-Signals vor einer Demodulation und eines Nutzsignalsanteils nach einer Demodulation ermittelt wird. Je größer dieses Störsignal ist, um so größer ist auch der Strombedarf des Mobilfunkgerätes, um die geforderten Großsignalanforderungen (die Resistenz gegenüber von Störsignalen) zu erfüllen.

Somit läßt sich also über die Messung dieses Störsignales der augenblickliche Strombedarf ermitteln, der es dem Mobilfunkgerät ermöglicht, ein Nutzsignal in einer definierten Qualität zu empfangen.

Gemäß diesem Gedanken schlägt der Erfinder also vor, ein Verfahren zum Empfang eines HF-Signales, das aus einem Nutzsignalanteil und einem Störsignalanteil besteht, wobei zumindest der Nutzsignalanteil einem Empfänger zugeleitet wird, der das Signal verstärkt, filtert, demoduliert, also ins Basisband heruntermischt, und ausgibt, dahingehend weiterzuentwickeln, daß der Störsignalanteil aus der Messung des gesamten eingehenden HF-Signals vor einer Demodulation und des Nutzsignalanteils nach einer Demodulation ermittelt wird und je nach Größe des Störsignalanteils eine Empfängerleistungsaufnahme eingestellt wird. Ein Empfangsparameter kann also derart angepaßt werden, daß eine Reduktion der aufgenommenen Leistung erreicht wird.

Wie dargelegt wird der Störsignalanteil aus einer Messung des gesamten HF-Signals vor einer Demodulation und des Nutzsignalanteils nach einer Demodulation erhalten. So können HF-Signal und Nutzsignalanteil miteinander verglichen werden. Da HF-Signal und Nutzsignalanteil aber im allgemeinen unterschiedliche Pegel aufweisen, sollten sie vor einem Vergleich geeignet bewertet werden. Zum Beispiel wird eines der beiden Signale mit einem Korrekturfaktor multipliziert, um einen Vergleich zwischen HF-Signal und Nutzsignalanteil zu ermöglichen. Weiterhin kann auch eine Tabelle erzeugt werden, in der der absolute Nutzsignalanteil, der absolute Störsignalanteil, deren Verhältnis zueinander und eine daraus resultierende Großsignalfestigkeit einander zugeordnet werden.

In einer bevorzugten Weiterentwicklung des Verfahrens werden weitere Parameter zur Bewertung der Störsituation herangezogen. Diese Parameter sind die aktuell eingestellte Sendeleistung, die für den Empfänger ebenfalls ein Störsignal darstellt, sowie eine aktuelle Bitfehlerrate. Die Einbeziehung dieser Parameter in die Bewertung der Störsituation gewährleistet eine optimierte Beurteilung der Störsituation und somit auch des benötigten Stromflusses durch den Empfänger.

In einer weiteren Ausführung des Verfahrens wird das Störsignal breitbandig gemessen. Die Messung des Störsignals kann in einem Frequenzbereich durchgeführt werden, der dem Frequenzbereich entspricht, der in der Systemspezifikation für Großsignalanforderungen angegeben ist. Sinnvollerweise kann die Messung des Störsignals auf den Frequenzbereich eingeschränkt sein, in dem die Großsignalanforderungen eine erhöhte Linearität und damit eine höhere Stromaufnahme bedingen.

Darüber hinaus wird vorzugsweise die Leistungsaufnahme eines Verstärkers und eines Mischers, die Funktionselemente (Stufen) des Empfängers darstellen, eingestellt, wobei der Verstärker als rauscharmer Vorverstärker ausgebildet sein kann. Dies kann durch Änderung des Arbeitspunktes, also Änderung des Stromflusses durch die Stufen erreicht werden.

Vorteilhaft werden die Funktionen des oben genannten Verfahrens, zumindest teilweise, in einer Analogschaltung durchgeführt. So kann zum Beispiel der Vergleich des Nutzsignalanteils mit dem HF-Signal über den Vergleich zweier Spannungen ausgeführt werden, und die Messung des Störsignals kann kontinuierlich erfolgen.

In einer weiteren vorteilhaften Ausführung werden die Funktionen des oben genannten Verfahrens, zumindest teilweise, als mindestens ein digitales Programm ausgeführt, wobei zum Beispiel digitale Signale miteinander verglichen werden. Ebenso kann die Messung des Störsignals schrittweise (digital); mit vorzugsweise 0,001 bis 5 Messungen pro Sekunde, erfolgen. Die sinnvolle Anzahl der Messungen hängt zum Beispiel vom augenblicklichen Betriebszustand des Endgerätes ab. So sind zum Beispiel im Stand-by-Modus eines Mobilfunkgerätes (Gerät im Netz eingebucht und auf Empfang, aber kein Gespräch) weniger Messungen nötig als während eines Gespräches, wenn wesentlich mehr Daten übertragen werden (und auch verloren gehen können).

Weiterhin schlägt der Erfinder vor, ein Mobilfunkgerät, mit mindestens einem Empfänger, der mindestens einen Verstärker enthält, und mindestens einem Sender, zur Übertragung und zum Empfang eines HF-Signals, das aus einem Nutzsignalanteil und einem Störsignalanteil besteht, dahingehend weiterzuentwickeln, daß ein Mittel zur Detektion des Störsignalanteils im Empfangssignal und ein Mittel zur Steuerung der Empfängerleistungsaufnahme vorgesehen ist, wobei die Empfängerleistungsaufnahme in Abhängigkeit von der Größe des Störsignalanteils eingestellt wird.

In einer bevorzugten Ausführung des erfindungsgemäßen Mobilfunkgerätes stellt das Mittel zur Detektion des Störsignalanteils einen breitbandigen HF-Pegeldetektor, zum Beispiel eine RSSI-Stufe (RSSI = Received Signal Strength Indicator) dar. Diese RSSI-Stufe liefert zum Beispiel eine zu der detektierten Signalleistung proportionale Spannung, die HF-Signalspannung, die weitergeleitet wird. Diese Detektion des Störsignalanteils kann nun entweder vor oder hinter einer ersten Verstärkerstufe des Empfängers geschehen.

Darüber hinaus kann das Mittel zur Steuerung der Empfängerleistungsaufnahme mindestens eine Verarbeitungseinheit und ein Mittel zur Messung des Nutzsignalanteils aufweisen.

Vorteilhaft ist diese Verarbeitungseinheit, zumindest teilweise, eine digitale Steuerelektronik. Hier werden die eintreffenden Informationen verarbeitet und Steuersignale generiert, die den Stromfluß durch den Empfänger, vorzugsweise durch einen Mischer und einen Vorverstärker, steuern.

In einer anderen vorteilhaften Ausführung ist die Verarbeitungseinheit, zumindest teilweise, eine analoge Steuerelektronik. Diese analoge Steuerelektronik führt beispielsweise die Subtraktion zweier Spannungen durch, wobei die eine Spannung einem aktuellen Nutzsignalanteil, die andere Spannung einem empfangenen HF-Signal entsprechen kann, um so einen aktuellen Störpegel zu erhalten und den Bedarf an Arbeitsstrom des Empfängers zu ermitteln beziehungsweise zu schätzen und entsprechend einzustellen.

In einer Weiterentwicklung des Mobilfunkgerätes weist das Mittel zur Messung des Nutzsignalanteils einen breitbandigen HF-Pegeldetektor, zum Beispiel eine RSSI-Stufe, auf. Diese RSSI-Stufe, die zu einer digitalen Empfängereinheit gehören kann, erfaßt lediglich den Nutzsignalanteil und generiert hieraus ein Ausgangssignal, das der Leistung des Nutzsignalanteils entspricht. Dieses Ausgangssignal wird nun der Verarbeitungseinheit zugeleitet, die dieses Signal weiterverarbeiten kann.

Vorteilhaft ist ein Mittel vorgesehen, das eine aktuelle Bitfehlerrate ermittelt. So liefern Mobiltelefone, die nach dem GSM Standard arbeiten, der Basisstation regelmäßig einen Parameter, mit dem die Bitfehlerrate im empfangenen Signal rückgemeldet wird. Dieser Parameter kann zum Beispiel in einem Viterbi Decoder ermittelt werden.

Darüber hinaus können aus verschiedenen weiteren Parametern, wie zum Beispiel aus einem Nutzsignalpegel, einer Dopplerverschiebung und einem Grad der Mehrwegeausbreitung, weitere Rückschlüsse auf die Ursache einer Erhöhung der Bitfehlerrate gezogen werden und im Falle eines Hinweises auf Großsignaleinfluß die Linearität des Empfängers, also seine Stromaufnahme, erhöht werden.

In einer vorteilhaften Weiterentwicklung des erfindungsgemäßen Mobilfunkgerätes ist ein Mittel vorgesehen, das eine aktuell eingestellte Sendeleistung ermittelt. Für hohe Sendeleistungen, also Sendeleistungen, die oberhalb von 0 bis -5 dBm liegen, wird ein Teil der Sendeleistung (in einem TX Pfad) ausgekoppelt und detektiert. Dadurch läßt sich nach einer Abgleichprozedur bei der Herstellung eine Leistungsmessung durchführen. Für kleine Ausgangsleistungen erfolgt während der Abgleichprozedur lediglich eine Zuordnung von Steuerspannungen der Verstärker zur gemessenen Ausgangsleistung. Im Betrieb wird nun diese im Mobiltelefon gespeicherte Zuordnung verwendet, um definiert Sendeleistungen einstellen zu können.

In einer weiteren vorteilhaften Ausgestaltung des Mobilfunkgerätes ist mindestens ein Mittel vorgesehen, das Sende- und Empfangspfad voneinander isoliert.

Eine Ausgestaltung der Erfindung sieht vor, daß das mindestens eine Mittel als HF-Schalter ausgestaltet ist. Hierbei werden Empfänger und Sender durch mindestens einen HF-Schalter mit der Antenne verbunden. Diese Ausgestaltung kann dann verwendet werden, wenn zu einem Zeitpunkt entweder empfangen oder gesendet wird, wie dies für GSM Systeme (GSM = Global System for Mobile Communication) immer und für GPRS (General Packet Radio Service) und EDGE (Enhanced Data GSM Environment) Systeme in Abhängigkeit einer Klassifizierung unter Umständen der Fall ist. GPRS und EDGE Systeme unterteilen sich in verschiedene Klassen, die verschieden lange Sende- und Empfangszyklen erfordern. Bis zu einer bestimmten Klasse läßt sich das Senden und Empfangen noch sequentiell durchführen, darüber hinaus überlappen sich dann zumindest teilweise die Sende- und die Empfangsphasen. Somit ist unter Umständen auch bei GPRS und EDGE Systemen ein HF-Schalter als Mittel zum Isolieren von Sende- und Empfangspfad verwendbar.

In einer anderen beispielhaften Ausgestaltung des Mobilfunkgerätes ist das mindestens eine Mittel als Filter ausgestaltet. Beispielsweise kann dieses Filter ein Duplexfilter darstellen, das Signalpfade von dem Sender und dem Empfänger kombiniert, Sende- und Empfangspfad voneinander isoliert und passierende Signalspektren filtert. Ein sinnvolles Einsatzgebiet dieses Duplexfilters ist bei Systemen, die gleichzeitig senden und empfangen (Vollduplex Systeme), wie beispielsweise GPRS und EDGE. Aber auch Vollduplex Systeme brauchen nicht zwingend ein Duplexfilter, da man Sende- und Empfangszug jeweils mit einer eigene Antenne versehen könnte. Die Filterwirkung des Duplexfilters könnte dann durch getrennte Einzelfilter für Sender u. Empfänger realisiert werden.

Es versteht sich, daß Steuerleitungen vorgesehen sind, über die Signale den einzelnen Funktionseinheiten des Mobilfunkgerätes zugeleitet werden, wie zum Beispiel die Steuersignale von der Verarbeitungseinheit zu dem Empfänger oder die Signale von den HF-Pegeldetektoren (RSSI-Stufen) zu der Verarbeitungseinheit.

Weitere Merkmale der Erfindung ergeben sich aus den Unteransprüchen und der nachfolgenden Beschreibung zweier Ausführungsbeispiele unter Bezugnahme auf die Zeichnungen.
Es zeigen:
- Figur 1:: ein Blockschaltbild eines erfindungsgemäßen Mobiltelefons, mit einer RSSI-Stufe vor einem Verstärker;
- Figur 2:: ein Blockschaltbild eines erfindungsgemäßen Mobiltelefons, mit der RSSI-Stufe hinter dem Verstärker.

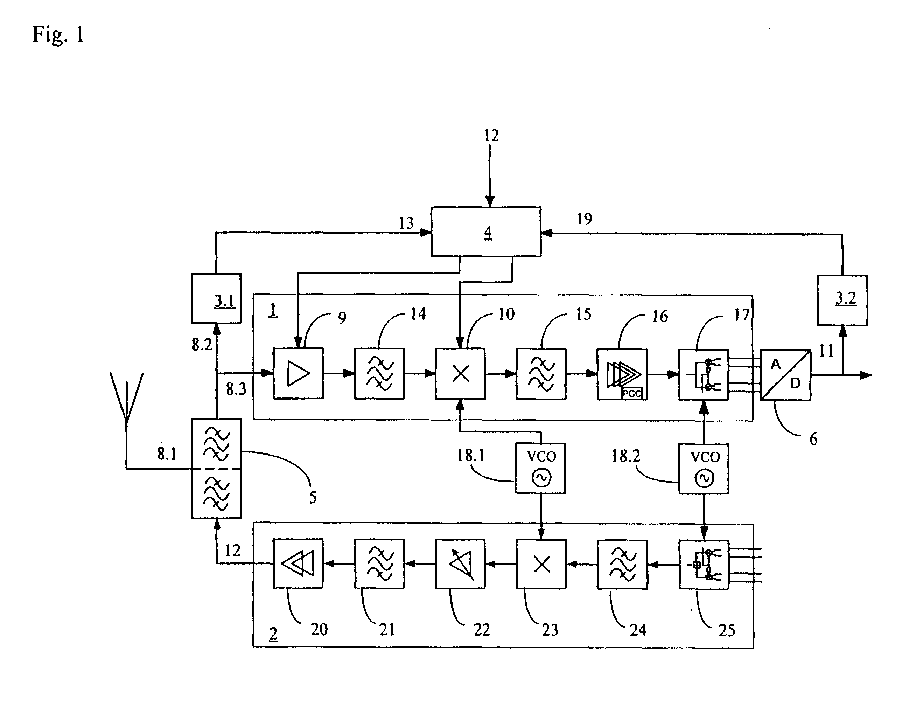

Die Figur 1 zeigt ein Blockschaltbild eines bevorzugten Ausführungsbeispiels eines erfindungsgemäßen Mobiltelefons mit einem Duplexfilter 5, einem A/D-Wandler 6, zwei RSSI-Stufen 3.1 und 3.2, einer Kontrolleinheit 4, zwei Oszillatoren 18.1 und 18.2 sowie einem Empfänger 1 und einem Sender 2.

Ein eingehendes HF-Signal 8.1, das aus einem Nutzsignalanteil 11 und einem Störsignalanteil besteht, durchläuft den Duplexfilter 5, der die Signalpfade des Senders 2 und des Empfängers 1 frequenzselektiv trennt beziehungsweise, je nach Signalflußrichtung, kombiniert. Im Duplexfilter 5 geschieht neben der RX/TX-Aufteilung, also der Aufteilung von eingehendem und ausgehendem Signal, auch eine Bandfilterung zur Verminderung von Außerband-Störsignalen.

Ein Teil 8.2 des eingehenden HF-Signals 8.1 wird vor dem Empfänger 1 ausgekoppelt, zum Beispiel mit Hilfe eines Richtkopplers, eines Leistungsteilers oder schlicht durch resistive Auskopplung, und durch die RSSI-Stufe 3.1 geleitet. Diese RSSI-Stufe 3.1 detektiert breitbandig die Leistung des HF-Signals 8.2 und liefert eine der detektierten Signalleistung proportionale HF-Signalspannung 13. Diese HF-Signalspannung 13 wird der Verarbeitungseinheit, also der Kontrolleinheit 4, zugeführt.

Der andere Teil des HF-Signals 8.3 durchläuft den Empfänger 1, der den Störsignalanteil des Signals 8.3 durch Filterung abtrennt. Der Empfänger 1 enthält einen rauscharmen Vorverstärker 9, einen HF-Filter 14, einen Mischer 10, einen ZF-Filter 15 (ZF=Zwischenfrequenz), einen ZF-Verstärker 16 sowie einen IQ-Demodulator 17 (IQ = In-Phase und Quadrature Komponente = Basisband-Signalanteile von gängigen digitalen Modulationsverfahren), der das Signal demoduliert.

Das HF-Signal 8.3 wird im rauscharmen Vorverstärker 9 verstärkt und anschließend nochmals per HF-Filter 14 (Bandfilter) gefiltert. Danach wird das HF-Signal 8.3 im Mischer 10, unabhängig vom gewählten Kanal, auf eine konstante Zwischenfrequenz umgesetzt, auf der anschließend mit Hilfe des ZF-Filters 15 eine steilflankige Kanalfilterung geschieht. Das Nutzsignal wird hierbei weitgehend von allen Störanteilen befreit. In dem nachfolgenden ZF-Verstärker 16 findet der Hauptteil der Signalverstärkung statt.
Schließlich wird das Nutzsignal im IQ-Demodulator 17 demoduliert, das heißt in das Basisband heruntergemischt.

An dem Ausgang des Empfängers 1 durchläuft das Signal nun einen A/D-Wandler 6, der das bis dahin analoge Signal in ein digitales Signal umwandelt. Nach Durchlaufen des HF-Signals 8.3 durch die einzelnen Stufen des Empfängers 1 liegt nun hauptsächlich der Nutzsignalanteil 11 vor. Es folgt eine weitere Kanalfilterung durch ein praktisch ideales, also rechteckförmiges digitales Filter, welches restlos alle außerhalb des Nutzkanals liegende Störanteile entfernt (im Blockschaltbild nicht dargestellt).

Ein Teil dieses Nutzsignalanteils 11 wird abgetrennt (ausgekoppelt) und durch eine weitere RSSI-Stufe 3.2 geleitet. Das in der RSSI-Stufe 3.2 generierte Ausgangssignal 19 ist proportional der Leistung des Nutzsignalanteils 11 und wird der Verarbeitungseinheit 4 zugeführt.

Der Oszillator 18.1 führt dem Mischer 10 und der Oszillator 18.2 dem IQ-Demodulator 17 jeweils eine Frequenz zu, mit deren Hilfe das Eingangssignal des Mischers 10 auf die gewünschte Ausgangsfrequenz umgesetzt wird. Im Falle einer ZF-Frequenz von beispielsweise 318 MHz liegt die Oszillatorfrequenz entweder 318 MHz oberhalb oder unterhalb der umzusetzenden Mischer-Eingangsfrequenz, da in beiden Fällen das Mischprodukt die Differenz zwischen Eingangssignal und Oszillatorsignal ist. Die Oszillatorfrequenz ist also die Empfangsfrequenz ± ZF-Frequenz. Im Falle des IQ-Modulators 25 ist die ZF-Frequenz 0 Hz (Basisband) und folglich sind Eingangs- und Oszillatorfrequenz identisch (in diesem Beispiel 318 MHz).

Der Sender 2 besteht aus einem Leistungsverstärker 20, einem HF-Filter 21, einem Treiber 22, einem TX-Mischer 23, aus einem weiteren Filter 24 und einem IQ-Modulator 25. In dem Sender 2 wird das im Basisband vorliegende analoge Signal, das die digitalen Informationen enthält, zunächst mittels des IQ-Modulators 25 moduliert und dabei mittels des in dem Oszillator 18.2 erzeugten Sinussignals, in eine ZF-Lage umgesetzt. Anschließend erfolgt eine Kanalfilterung mit dem Filter 24, um das Signal von Störsignalen, die bei der Modulation erzeugt werden aber unerwünscht sind, zu befreien. Das Signal wird anschließend dem TX-Mischer 23 zugeführt, in dem es mittels eines Sinussignals aus dem Oszillator 18.1 in eine HF-Lage umgesetzt wird. Die prinzipiellen Abhängigkeiten der Mischfrequenzen sind dabei analog zu dem Mischer 10 des Empfängers 1, die Höhe der ZF-Frequenz ist im allgemeinen jedoch verschieden von der ZF-Frequenz in dem Empfänger 1. Das resultierende HF-Signal wird anschließend dem Treiber 22, einem Verstärker mit einstellbarer Verstärkung, zugeführt, der eine Einstellung der Sendeleistung ermöglicht und dann in dem HF-Filter 21 von unerwünschten, außerhalb des Sendebandes liegenden, Frequenzanteilen befreit. Schließlich wird das Signal mittels des Leistungsverstärkers 20 auf die gewünschte Solleistung verstärkt und dem Duplexfilter 5 zugeführt, in dem es gefiltert und zu der Antenne weitergeleitet wird.

Die Verarbeitungseinheit 4 ist zum Beispiel eine Steuerelektronik, die mit Hilfe eines Algorithmus' die eingehenden Signale verarbeitet. Aus der HF-Signalspannung 13 und dem Ausgangssignal 19, die beide in der Verarbeitungseinheit 4 bewertet und miteinander verglichen werden, wird das aktuelle Störsignal bestimmt. Zusätzlich zu diesem Störsignal werden Informationen zur aktuell eingestellten Sendeleistung 12 sowie zu einer aktuellen Bitfehlerrate herangezogen, um den tatsächlich benötigten Strombedarf des Empfängers 1 zu ermitteln beziehungsweise zu schätzen. Die Verarbeitungseinheit 4 paßt den Stromfluß durch den rauscharmen Vorverstärker 9 sowie den Mischer 10 an und steuert somit die erforderliche Linearität beziehungsweise Großsignalfestigkeit des Empfängers 1.

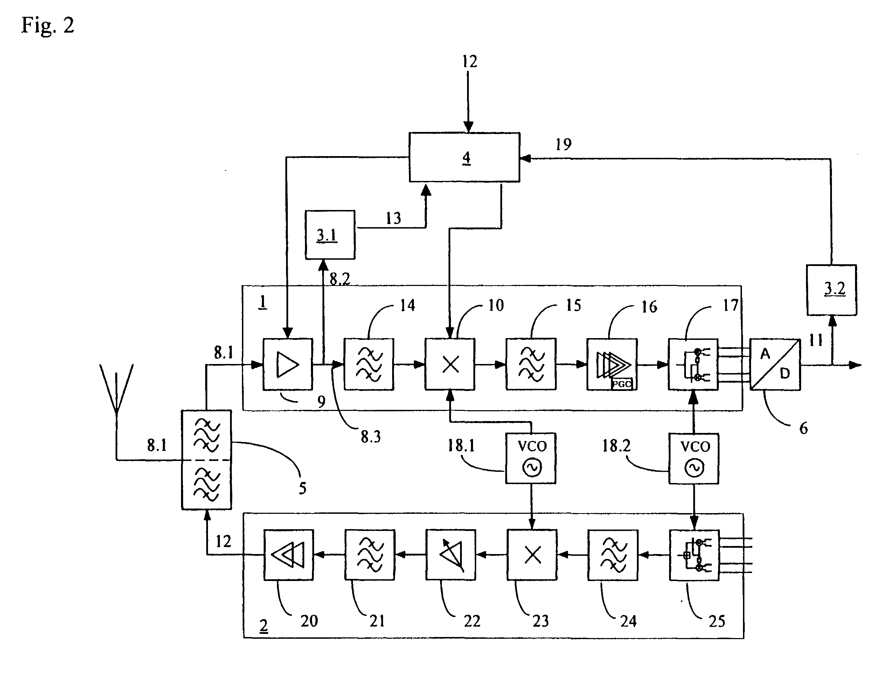

Die Figur 2 zeigt ein weiteres Ausführungsbeispiel, wobei hier, im Unterschied zu der Figur 1, ein HF-Signalanteil 8.2 nach dem rauscharmen Vorverstärker 9 ausgekoppelt wird und der RSSI-Stufe 3.1 zugeleitet wird.

Bei dieser Variante wird die durch den Vorverstärker 9 zur Verfügung gestellte Verstärkung genutzt. Die RSSI-Stufe 3.1 muß nun entsprechend weniger Verstärkung liefern, um ein brauchbares Ausgangssignal zu erzeugen. Dadurch kann die Stromaufnahme der RSSI-Stufe 3.1 gesenkt werden.

Hierbei ist aber zu beachten, daß bei sehr großen Störsignalen dieser erste Verstärker 9 wegen mangelnder Linearität bereits zu einer Signalkompression führen könnte, wodurch die RSSI-Einheit 3.1 nicht die korrekte Signalpegelinformation liefert.

Es versteht sich, daß die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

Insgesamt wird durch die Erfindung erreicht, daß ein Verfahren zur Verfügung gestellt wird, das es ermöglicht, die Betriebszeit eines Mobilfunkgerätes zu verlängern, ohne daß die Leistung der Batterie erhöht oder eine größere Batterie verwendet wird. Weiterhin wird ein Mobilfunkgerät zur Durchführung des erfindungsgemäßen Verfahrens vorgestellt.

### Bezugszeichenliste

- 1: Empfänger
- 2: Sender
- 3.X: RSSI-Stufe
- 4: Verarbeitungseinheit
- 5: Duplexfilter
- 6: A/D-Wandler
- 8.X: HF-Signal
- 9: Vorverstärker
- 10: Mischer
- 11: Nutzsignalanteil
- 12: Sendeleistung
- 13: HF-Signalspannung
- 14: HF-Filter
- 15: ZF-Filter
- 16: ZF-Verstärker
- 17: IQ-Demodulator
- 18.X: Oszillator
- 19: Ausgangssignal
- 20: Leistungsverstärker
- 21: HF-Filter
- 22: Treiber
- 23: TX-Mischer
- 24: Filter
- 25: IQ-Modulator

## Patentansprüche

1. Verfahren zum Empfang eines HF-Signales (8.X), das aus einem Nutzsignalanteil (11) und einem Störsignalanteil besteht, wobei zumindest der Nutzsignalanteil (11) einem Empfänger (1) zugeleitet wird, der das Signal verstärkt, filtert, demoduliert und ausgibt, **dadurch gekennzeichnet, daß** der Störsignalanteil des HF-Signals entweder vor oder hinter einer ersten Verstärkerstufe (9) aus der Messung des gesamten eingehenden HF-Signals (8.X) vor einer Demodulation und des Nutzsignalanteils (11) nach einer Demodulation ermittelt wird und je nach Größe des Störsignalanteils eine Empfängerleistungsaufnahme eingestellt wird.

2. Verfahren gemäß Anspruch 1 , **dadurch gekennzeichnet, daß** die Empfängerleistungsaufnahme je nach Größe einer aktuell eingestellten Sendeleistung (12) und/oder einer aktuellen Bitfehlerrate eingestellt wird.

3. Verfahren gemäß einem der voranstehenden Ansprüche 1 bis 2, **dadurch gekennzeichnet, daß** das Störsignal breitbandig gemessen wird.

4. Verfahren gemäß einem der voranstehenden Ansprüche 1 bis 3, **dadurch gekennzeichnet, daß** die Leistungsaufnahme eines Verstärkers (9) und/oder eines Mischers (10), die Funktionselemente des Empfängers (1) darstellen, eingestellt wird.

5. Verfahren gemäß einem der voranstehenden Ansprüche 1 bis 4, **dadurch gekennzeichnet, daß** die Funktionen des Verfahrens gemäß einem der Ansprüche 1 bis 4, zumindest teilweise, in mindestens einer Analogschaltung durchgeführt werden.

6. Verfahren gemäß einem der voranstehenden Ansprüche 1 bis 5, **dadurch gekennzeichnet, daß** die Funktionen des Verfahrens gemäß einem der Ansprüche 1 bis 5, zumindest teilweise, als mindestens ein digitales Programm ausgeführt werden.

7. Mobilfunkgerät, mit mindestens einem Empfänger (1), der eine erste Verstärkerstufe (9) enthält, und mindestens einem Sender (2), zur Übertragung und zum Empfang eines HF-Signals (8.X), das aus einem Nutzsignalanteil (11) und einem Störsignalanteil besteht, **dadurch gekennzeichnet, daß** ein Mittel (3.1) zur Detektion des Störsignalanteils des HF-Signals entweder vor oder hinter der ersten Verstärkerstufe (9) und ein Mittel (4, 3.2) zur Steuerung der Empfängerleistungsaufnahme vorgesehen ist, wobei die Empfängerleistungsaufnahme in Abhängigkeit von der Größe des Störsignalanteils eingestellt wird.

8. Mobilfunkgerät gemäß dem voranstehenden Anspruch 7, **dadurch gekennzeichnet, daß** das Mittel zur Detektion des Störsignalanteils einen breitbandigen HF-Pegeldetektor (3.1) aufweist.

9. Mobilfunkgerät gemäß einem der voranstehenden Ansprüche 7 bis 8, **dadurch gekennzeichnet, daß** das Mittel zur Steuerung der Empfängerleistungsaufnahme mindestens eine Verarbeitungseinheit (4) und ein Mittel (3.2) zur Messung des Nutzsignalanteils (11) aufweist.

10. Mobilfunkgerät gemäß dem voranstehenden Anspruch 9, **dadurch gekennzeichnet, daß** die Verarbeitungseinheit (4), zumindest teilweise, eine digitale Steuerelektronik ist.

11. Mobilfunkgerät gemäß einem der voranstehenden Ansprüche 9 bis 10, **dadurch gekennzeichnet, daß** die Verarbeitungseinheit (4), zumindest teilweise, eine analoge Steuerelektronik ist.

12. Mobilfunkgerät gemäß einem der voranstehenden Ansprüche 7 bis 11, **dadurch gekennzeichnet, daß** das Mittel zur Messung des Nutzsignalanteils (11) einen weiteren breitbandigen HF-Pegeldetektor (3.2) aufweist.

13. Mobilfunkgerät gemäß einem der voranstehenden Ansprüche 7 bis 12, **dadurch gekennzeichnet, daß** ein Mittel vorgesehen ist, das eine aktuelle Bitfehlerrate ermittelt.

14. Mobilfunkgerät gemäß einem der voranstehenden Ansprüche 7 bis 13, **dadurch gekennzeichnet, daß** ein Mittel vorgesehen ist, das eine aktuell eingestellte Sendeleistung (12) ermittelt.

15. Mobilfunkgerät gemäß einem der voranstehenden Ansprüche 7 bis 14, **dadurch gekennzeichnet, daß** mindestens ein Mittel (5) vorgesehen ist, das Sende- und Empfangspfad voneinander isoliert.

16. Mobilfunkgerät gemäß dem voranstehenden Anspruch 15, **dadurch gekennzeichnet, daß** das mindestens eine Mittel einen Filter (5) darstellt.

17. Mobilfunkgerät gemäß einem der voranstehenden Ansprüche 15 bis 16, **dadurch gekennzeichnet, daß** das mindestens eine Mittel (5) einen Schalter darstellt.

## Claims

1. Method for receiving an HF signal (8.X) comprising a useful signal component (11) and an interference signal component, with at least the useful signal component (11) being routed to a receiver (1) that amplifies, filters, demodulates and outputs the signal,
**characterised in that** the interference signal component of the HF signal is determined either before or after a first amplifier stage (9) from the measurement of the entire incoming HF signal (8.X) before demodulation and the useful signal component (11) after demodulation and a receiver power input is set on the basis of the size of the interference signal component.

2. Method according to Claim 1,
**characterised in that** the receiver power input is set on the basis of the size of the currently set transmission power (12) and/or a current bit error rate.

3. Method according to one of the preceding Claims 1 to 2,
**characterised in that** the interference signal is measured using broadband.

4. Method according to one of the preceding Claims 1 to 3,
**characterised in that** the power input of an amplifier (9) and/or a mixer (10), which represent functional elements of the receiver (1), is set.

5. Method according to one of the preceding Claims 1 to 4,
**characterised in that** the functions of the method according to one of Claims 1 to 4 are implemented, at least partially, in at least one analogue circuit.

6. Method according to one of the preceding Claims 1 to 5,
**characterised in that** the functions of the method according to one of Claims 1 to 5 are executed, at least partially, as at least one digital program.

7. Mobile radio device with at least one receiver (1), which includes a first amplifier stage (9), and at least one transmitter (2) for transmitting and receiving an HF signal (8.X), which comprises a useful signal component (11) and an interference signal component,
**characterised in that** means (3.1) are provided for detecting the interference signal component of the HF signal either before of after the first amplifier stage (9) and means (4, 3.2) are provided for controlling the receiver power input, with the receiver power input being set as a function of the size of the interference signal component.

8. Mobile radio device according to the preceding Claim 7,
**characterised in that** the means for detecting the interference signal component have a broadband HF level detector (3.1).

9. Mobile radio device according to one of the preceding Claims 7 to 8,
**characterised in that** the means for controlling the receiver power input have at least one processing unit (4) and means (3.2) for measuring the useful signal component (11).

10. Mobile radio device according to the preceding Claim 9,
**characterised in that** the processing unit (4) is, at least partially, a digital electronic control system.

11. Mobile radio device according to one of the preceding Claims 9 to 10,
**characterised in that** the processing unit (4) is, at least partially, an analogue electronic control system.

12. Mobile radio device according to one of the preceding Claims 7 to 11,
**characterised in that** the means for measuring the useful signal component (11) have a further broadband HF level detector (3.2).

13. Mobile radio device according to one of the preceding Claims 7 to 12,
**characterised in that** means are provided that determine the current bit error rate.

14. Mobile radio device according to one of the preceding Claims 7 to 13,
**characterised in that** means are provided that determine the currently set transmission power (12).

15. Mobile radio device according to one of the preceding Claims 7 to 14,
**characterised in that** at least one means (5) is provided to insulate the transmission path and the receiving path from each other.

16. Mobile radio device according to the preceding Claim 15,
**characterised in that** the at least one means represents a filter (5).

17. Mobile radio device according to one of the preceding Claims 15 to 16,
**characterised in that** the at least one means (5) represents a switch.

## Revendications

1. Procédé de réception d'un signal HF (8.X) constitué d'une partie utile (11) de signal et d'une partie parasite de signal, au moins la partie utile (11) du signal étant transmise à un récepteur (1) qui amplifie le signal, le filtre, le démodule et le délivre, **caractérisé en ce que** la partie parasite du signal HF est déterminée soit avant ou après un premier étage d'amplification (9) à partir de la mesure de la totalité du signal HF (8.X) entrant avant démodulation et la partie utile (11) du signal après démodulation, la puissance absorbée au récepteur étant réglée en fonction du niveau de la partie parasite du signal.

2. Procédé selon la revendication 1, **caractérisé en ce que** la puissance absorbée au récepteur est réglée en fonction de niveau de la puissance d'émission (12) réglée actuellement et/ou à partir d'un taux d'erreur actuel sur les bits.

3. Procédé selon l'une des revendications qui précèdent 1 à 2, **caractérisé en ce que** le signal parasite est mesuré sur une large bande.

4. Procédé selon l'une des revendications qui précèdent 1 à 3, **caractérisé en ce que** l'on y règle la puissance absorbée par l'amplificateur (9) et/ou le mélangeur (10) qui constituent des éléments fonctionnels du récepteur (1).

5. Procédé selon l'une des revendications qui précèdent 1 à 4, **caractérisé en ce que** les fonctions du procédé selon l'une des revendications 1 à 4 sont exécutées au moins en partie dans au moins un circuit analogique.

6. Procédé selon l'une des revendications qui précèdent 1 à 5, **caractérisé en ce que** les fonctions du procédé selon l'une des revendications 1 à 5 sont exécutées au moins en partie sous la forme d'au moins un programme numérique.

7. Radiotéléphone qui comporte au moins un récepteur (1) qui contient un premier étage d'amplification (8) et au moins un émetteur (2), pour la transmission et la réception d'un signal HF (8.X) qui est constitué d'une partie utile (11) du signal et d'une partie parasite du signal, **caractérisé en ce qu'**un moyen (3.1) de détection de la partie parasite du signal HF est prévue soit en amont ou en aval du premier étage d'amplification (9) et **en ce qu'**un moyen (4, 3.2) de commande de la puissance absorbée au récepteur est prévu, la puissance absorbée au récepteur étant réglée en fonction du niveau de la partie parasite du signal.

8. Radiotéléphone mobile selon la revendication 7 qui précède, **caractérisé en ce que** le moyen de détection de la partie parasite du signal présente un détecteur (3.1) de niveau HF à large bande.

9. Radiotéléphone mobile selon l'une des revendications 7 à 8 qui précèdent, **caractérisé en ce que** le moyen de commande du niveau de réception présente au moins une unité de traitement (4) et un moyen (3.2) de mesure de la partie utile (11) du signal.

10. Radiotéléphone mobile selon la revendication 9 qui précède, **caractérisé en ce que** l'unité de traitement (4) est au moins en partie une électronique de commande numérique.

11. Radiotéléphone mobile selon l'une des revendications 9 à 10 qui précèdent, **caractérisé en ce que** l'unité de traitement (4) est au moins en partie une électronique de commande analogique.

12. Radiotéléphone mobile selon l'une des revendications 7 à 11 qui précèdent, **caractérisé en ce que** le moyen de mesure de la partie utile (11) du signal présente un autre détecteur (3.2) de niveau HF à large bande.

13. Radiotéléphone mobile selon l'une des revendications 7 à 12 qui précèdent, **caractérisé en ce qu'**un moyen y est prévu pour déterminer le taux d'erreur actuel sur les bits.

14. Radiotéléphone mobile selon l'une des revendications 7 à 13 qui précèdent, **caractérisé en ce qu'**un moyen y est prévu pour déterminer la puissance d'émission (12) réglée actuellement.

15. Radiotéléphone mobile selon l'une des revendications 7 à 14 qui précèdent, **caractérisé en ce qu'**au moins un moyen (5) y est prévu pour isoler l'un de l'autre le parcours d'émission et le parcours de réception.

16. Radiotéléphone mobile selon la revendication 15 qui précède, **caractérisé en ce que** l'au moins un moyen prévu est un filtre (5).

17. Radiotéléphone mobile selon l'une des revendications 15 à 16 qui précèdent, **caractérisé en ce que** l'au moins un moyen prévu (5) est un commutateur.
